# EUROPEAN PATENT APPLICATION

(11) **EP 1 603 204 A1**
(43) Date of publication of application: **07.12.2005**
(21) Application number: 04715453.9
(22) Date of filing: 27.02.2004
(51) Int. Cl.: H01S 5/028

(54) **MULTI-WAVELENGTH SEMICONDUCTOR LASER DEVICE AND ITS MANUFACTURING METHOD**

(30) Priority: 11.03.2003 JP 2003065186
(71) Applicant: Pioneer Corporation, Tokyo 153-8654 (JP)
(72) Inventor: MIYACHI, Mamoru; c/o Pioneer Corporation, Tsurugashima-shi, Saitama 350-2288 (JP); WATANABE, Atsushi; c/o Pioneer Corporation, Tsurugashima-shi, Saitama 350-2288 (JP); KIMURA, Yoshinori; c/o Pioneer Corporation, Tsurugashima-shi, Saitama 350-2288 (JP)
(74) Representative: Manitz, Finsterwald & Partner GbR
(86) International application number: PCT/JP2004/002351
(87) International publication number: WO 2004/082085

(57) **Abstract**

A multi-wavelength semiconductor laser device having a high reflectance multi-layered film that can be collectively formed on a facet of a semiconductor laser element is provided. The multi-wavelength semiconductor laser device is made of a plurality of semiconductor laser elements each of which oscillates at a wavelength different from each other. The plurality of semiconductor laser elements each have a reflective film that is deposited on at least one of a front facet and a backside facet thereof and has the same multilayer structure. The reflective film has, disposed in a film thickness direction, a first reflective region that has a first predetermined reflectance to a first wavelength that is oscillated from a first semiconductor laser element of the semiconductor laser elements; and a second reflective region that has a second predetermined reflectance to a second wavelength that is oscillated from, other than the first semiconductor laser element, a second semiconductor laser element and is different from the first wavelength.

## Description

### TECHNICAL FIELD

The present invention relates to a semiconductor laser device, in particular, a multi-wavelength semiconductor laser device made of a plurality of semiconductor laser elements that oscillate at mutually different wavelengths, and a manufacturing method thereof.

### BACKGROUND ART

In an existing monolithic two-wavelength laser made of two semiconductor laser elements, high reflectance coatings at faces thereof are each formed as a film having a different structure by making use of a mask. In the case of a multi-layered film most suitable for a first wavelength being formed, by covering a facet of the second semiconductor laser element of the second wavelength with a mask, on the contrary, in the case a multi-layered film most suitable for a second wavelength being formed, by covering a facet of the first semiconductor laser element of the first wavelength with a mask, a high reflectance coating of the multi-layered film most suitable for each is separately formed. A distance between light emitting spots of two wavelengths of the monolithic two-wavelength laser is one hundred and several tens micrometers or less. Therefore, according to an existing method in which films having different structures are separately formed by use of the mask, high positioning accuracy is necessary, resulting in poor productivity.

Furthermore, in order to enable to more improve the productivity of two-wavelength semiconductor laser devices, a resonator having a multi-layered reflective film that can be used in two wavelength ranges has been proposed (JP-A-2001-57413). This two-wavelength semiconductor laser device has a structure of a multi-layered reflective film that has a film thickness that an optical length to an average wavelength λ of two wavelengths is (1/4 + j) × λ (j = 0, 1, 2, ...). The reason for adapting the film thickness to an average wavelength of two wavelengths is that in a multi-layered film of which wavelength is adapted to one wavelength range, the reflectance to the other wavelength is extremely deteriorated.

However, in such two-wavelength semiconductor laser device, since an average wavelength λ is deviated from both wavelengths, it is difficult to obtain high reflectance close to 100% for both wavelengths. In particular, in the case of a two-wavelength semiconductor laser device having relatively largely different wavelength ranges such as a 405 nm range and a 650 nm range being manufactured, differences of the respective wavelengths from the average wavelength become large. Therefore, it is furthermore difficult to dispose high reflectance multi-layered films to both wavelengths.

### DISCLOSURE OF INVENTION

In order to solve the above-mentioned problems, the present invention has an object, for example, to provide a multi-wavelength semiconductor laser device that has high reflectance multi-layered films that can be collectively formed with the same structure on two or more semiconductor laser element facets and a manufacturing method thereof.

According to the present invention, there is provided a multi-wavelength semiconductor laser device comprising:
a plurality of semiconductor laser elements that oscillate at wavelengths that are different from each other,
wherein the plurality of semiconductor laser elements have a reflective film that is deposited on at least one of a front facet and a backside facet thereof and has a multilayer structure common to the semiconductor laser elements,
wherein the reflective film includes first and second reflective regions disposed in a film thickness direction thereof, the first reflective region having a first predetermined reflectance to a first wavelength oscillated at a first semiconductor laser element of the semiconductor laser elements; and the second reflective region having a second predetermined reflectance to a second wavelength that is oscillated at a second semiconductor laser element other than the first semiconductor laser element and different from the first wavelength.

Furthermore according to the present invention, there is provided a method of manufacturing a multi-wavelength semiconductor laser device that includes a plurality of semiconductor laser elements each of which oscillates at a wavelength different from each other, comprising the steps of:
forming a laser bar for a plurality of semiconductor laser elements that oscillate at different wavelengths;
forming, over all facets of the laser bar corresponding to the plurality of semiconductor laser elements, a first reflective region that includes a plurality of dielectric films each of which is different in the refractive index from adjacently deposited ones and has a first predetermined reflectance to a first wavelength; and
forming, on the first reflective region, a second reflective region that includes a plurality of dielectric films each of which is different in the refractive index from adjacently deposited ones and has a second predetermined reflectance to a second wavelength that is oscillated by a second semiconductor laser element other than the first semiconductor laser element and different from the first wavelength.

### BRIEF DESCRIPTION OF THE DRAWINGS

Fig. 1 is a schematic sectional view showing a two-wavelength semiconductor laser device according to an embodiment according to the present invention.
Fig. 2 is a schematic perspective view showing the two-wavelength semiconductor laser device according to an embodiment according to the invention.
Fig. 3 is a schematic sectional view showing a multi-layered film of the two-wavelength semiconductor laser device according to an embodiment according to the invention.
Fig. 4 is a flowchart showing a method of determining a multi-layered film of the two-wavelength semiconductor laser device according to an embodiment according to the invention.
Figs. 5 through 10 are flowcharts partially showing a method of determining the multi-layered film of the two-wavelength semiconductor laser device according to an embodiment according to the invention.
Fig. 11 is a schematic sectional view showing the multi-layered film of the two-wavelength semiconductor laser device according to an embodiment according to the invention.
Fig. 12 is a graph showing, of the reflectance of the multi-layered film of the two-wavelength semiconductor laser device according to an embodiment according to the invention, dependency on film thickness of a phase adjustment region.
Fig. 13 is a schematic sectional view showing a multi-layered film of a two-wavelength semiconductor laser device according to another embodiment according to the invention.
Fig. 14 is a graph showing, of the reflectance of the multi-layered film of the two-wavelength semiconductor laser device according to another embodiment according to the invention, dependency on thickness in a phase adjustment region.
Fig. 15 is a schematic perspective view showing a two-wavelength semiconductor laser device according to still another embodiment according to the invention.

### DETAILED DESCRIPTION OF THE INVENTION

In the following, modes for carrying out the present invention will be detailed with reference to attached drawings.

### <Two-wavelength semiconductor laser device>

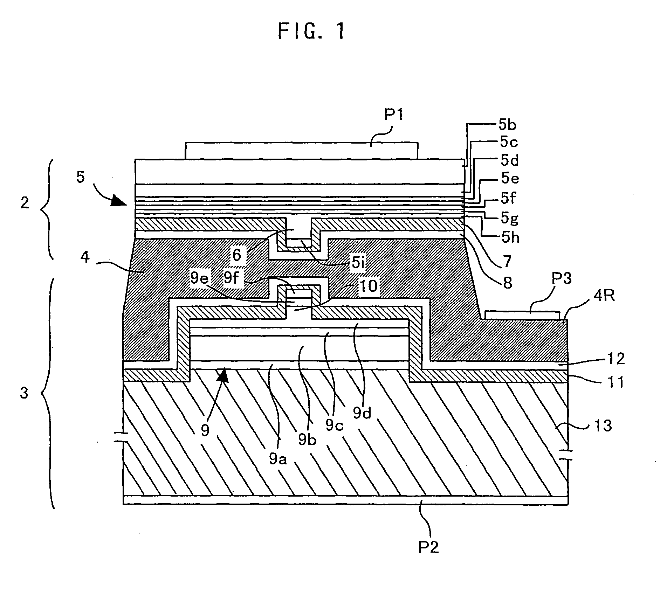

Fig. 1 is a sectional view showing an example in which a multi-wavelength semiconductor laser device according to the invention is applied to a two-wavelength semiconductor laser device 1. Such a two-wavelength semiconductor laser device 1 has a hybrid structure in which a first light-emitting element 2 that is a GaN-based compound semiconductor laser (405 nm band laser) and a second light-emitting element 3 that is an AlGaInP-based compound semiconductor laser (650 nm band laser) are solidly integrated with a fusing metal layer 4.

The first light-emitting element 2 includes a laser part 5 having a ridge stripe waveguide 6, and the second light-emitting element 3 includes a laser part 9 that is formed on an n-GaAs substrate 13 and has a ridge stripe waveguide 10.

Furthermore, an ohmic electrode P1 is formed on the laser part 5, an ohmic electrode P2 is formed on the n-GaAs substrate 13, and an ohmic electrode P3 is formed on an exposed portion 4R of the fusing metal layer 4.

When a driving current is supplied through the ohmic electrodes P1 and P3, 405 nm band laser light is emitted from the first light-emitting element 2. And when a driving current is supplied through the ohmic electrodes P2 and P3, 650 nm band laser light is emitted from the second light-emitting element 3.

The laser part 5 of the first light-emitting element 2 has a multilayer structure in which a bottom layer 5b, an n-type cladding layer 5c, an n-type guide layer 5d, an active layer 5e, an electron barrier layer 5f, a p-type guide layer 5g, a p-type cladding layer 5h and a p-type contact layer 5i are sequentially stacked in this order, wherein the p-type contact layer 5i and the p-type cladding layer 5h are partially etched and removed, and thereby the above ridge waveguide 6 is formed in a stripe shape that extends from this side of paper space toward a back side thereof.

Except for the p-type contact layer 5i of the ridge waveguide 6, on the whole surface of the p-type cladding layer 5h, an insulating layer 7 is formed, and further, on the whole surface of the p-type contact layer 5i and the insulating layer 7, an ohmic electrode layer 8 is formed.

Accordingly, the ridge waveguide 6 is electrically connected through the p-type contact layer 5i and the ohmic electrode layer 8 to the fusing metal layer 4.

More specifically, the bottom layer 5b is made of Si-doped n-type GaN and formed into a thickness in the range of substantially 5 to 15 µm. The n-type cladding layer 5c is made of n-type Al_{0.08}Ga_{0.92}N and formed into a thickness of substantially 0.8 µm. The n-type guide layer 5d is made of n-type GaN and formed into a thickness of substantially 0.2 µm.

The active layer 5e has a thickness of substantially several tens nanometers and a multiple quantum well structure that includes a well layer and a barrier layer that are made of InₓGa₁₋ₓN (0 ≤ x) different in the composition from one another, such as In_{0.08}Ga_{0.92}N and In_{0.01}Ga_{0.99}N. The electron barrier layer 5f is made of AlGaN and has a thickness of substantially 0.02 µm. The p-type guide layer 5g is made of Mg-doped p-type GaN and has a thickness of substantially 0.02 µm.

The p-type cladding layer 5h is made of p-type Al_{0.08}Ga_{0.92}N and has a thickness of substantially 0.4 µm. The p-type contact layer 5i is made of p-type GaN and has a thickness of substantially 0.1 µm.

Furthermore, the ohmic electrode layer 8 is made of any one of Pd, Pt, Au or Ni or an alloy thereof, and the insulating layer 7 is made of SiO₂ or the like.

Still furthermore, the fusing metal layer 4 is made of an alloy that is generated by fusing a fusing metal layer 4a made of Au and a fusing metal layer 4b made of Sn.

The laser part 9 of the second light-emitting element 3 has a multilayer structure in which on an n-type GaAs substrate 13, a n-type buffer layer 9a, an n-type cladding layer 9b, an active layer 9c, a p-type cladding layer 9d, a smoothing layer 9e and a p-type contact layer 9f are deposited in this order.

Subsequently, by removing the p-type contact layer 9f and the smoothing layer 9e and a part of the p-type cladding layer 9d by means of the etching or the like, the ridge waveguide 10 is formed in a stripe shape that extends from this side of the paper space to a back side thereof. Furthermore, after the ridge waveguide 10 is formed, with a region where the laser part 9 is to be formed and the ridge waveguide 10 masked, a non-masked region is etched to a relatively deep portion of the n-type GaAs substrate 13, and thereby the laser part 9 having a projected sectional shape as shown in Fig. 1 is formed.

An entire surface of the laser part 9 and the n-type GaAs substrate 13 except for the p-type contact layer 9f is covered with an insulating layer 11, and furthermore an ohmic electrode layer 12 is deposited on an entire surface of the p-type contact layer 9f and the insulating layer 11, and thereby the p-type contact layer 9f is electrically connected to the ohmic electrode layer 12 and further connected electrically through the ohmic electrode layer 12 to the fusing metal layer 4.

More specifically, the buffer layer 9a is made of Si-doped n-type GaAs and formed into a thickness of substantially 0.5 µm. The n-type cladding layer 9b is made of n-type Al_{0.35}Ga_{0.15} In_{0.5}P and formed into a thickness of substantially 1.2 µm.

The active layer 9c has a thickness of substantially ten and several nanometers and a strained quantum well structure made of GaInP and AlGaInP . The p-type cladding layer 9d is made of Zn-doped p-type Al_{0.35}Ga_{0.15} In_{0.5}P and has a thickness of substantially 1.2 µm. The smoothing layer 9e is made of p-type Ga_{0.51}In_{0.49}P and has a thickness of substantially 0.05 µm. The p-type contact layer 9f is made of p-type GaAs and has a thickness of substantially 0.2 µm.

Furthermore, the ohmic electrode layer 12 is made of any one of Ti, Pt, Cr, Au or Au-Zn or an alloy thereof, and the insulating layer 7 is made of SiO₂ or the like.

In manufacturing the two-wavelength semiconductor laser provided with the first and second light-emitting elements 2, 3, shown in Fig. 1, for instance, there are used a bonding technique with a fusing metal (fusing metal layer 4) and a laser liftoff technique as a removal technique of a substrate on which a GaN-based compound semiconductor is epitaxialy grown.

The first light-emitting element 2 is manufactured in such a way that, on a sapphire substrate, layers from the bottom layer 5b to the p-type contact layer 5i are deposited by means of MOCVD process or the like, followed by etching to form the laser part 5 and the ridge waveguide 6, and on the entire surface thereof, the insulating layer 7, the ohmic electrode layer 8 and the fusing metal layer 4 are sequentially deposited.

The second light-emitting element 3 is manufactured in such a way that, on the n-type GaAs substrate 13, layers from the n-type buffer layer 9a to the p-type contact layer 9f are deposited by means of MOCVD process or the like, followed by etching to form the laser part 9 and the ridge waveguide 10, and over the entire surface thereof, the insulating layer 11, the ohmic electrode layer 12 and the fusing metal layer 4 are sequentially deposited.

Wafers of the first and second light-emitting elements 2 and 3 are bonded through the respective fusing metal layers 4.

The sapphire substrate of the first light-emitting element 2 is removed by use of laser lift-off process. That is, UV light that transmits sapphire and is absorbed by GaN is irradiated from the back surface of the sapphire substrate to decompose GaN in the vicinity of the interface of sapphire and GaN, and thereby the sapphire substrate is peeled. At this time, in a region other than the laser part 9, the first light-emitting element 2 is not fused. Therefore, in the region, the exposure portion 4R of the fusing metal layer is formed.

By cleaving the GaAs substrate 13, a resonator facet is formed. The cleaved substrate i.e., a laser bar carrying semiconductor laser elements that oscillate at different wavelengths is formed.

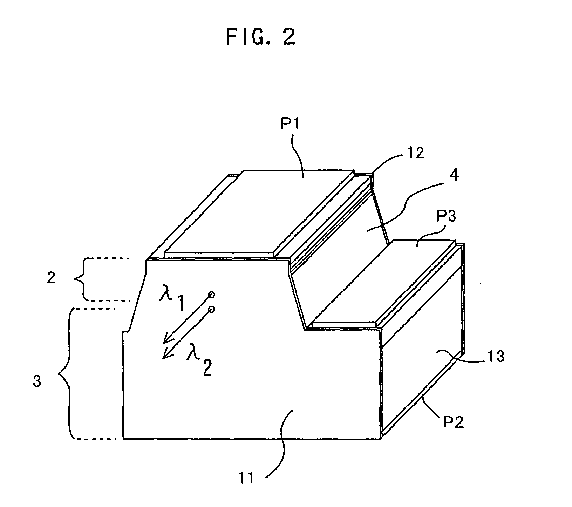

As shown in Fig. 2, on every facet of the resonator, a reflective film is collectively formed for each facet by means of sputtering process and so on. Here, a facet of laser diode is coated with a low reflectance film made of a single layer film of alumina, for example, and a backside facet is formed as a high reflectance film made of a multi-layered film described later. Since the resonator facet is formed by cleaving the GaAs substrate 13, the light emitting spots of the two light-emitting elements are in the same plane. The first light-emitting element 2 oscillates laser light having a wavelength λ₁ = 405 nm, and the second light-emitting element 3 oscillates laser light having a wavelength λ₂ = 650 nm.

### <Multi-layered film of backside facet>

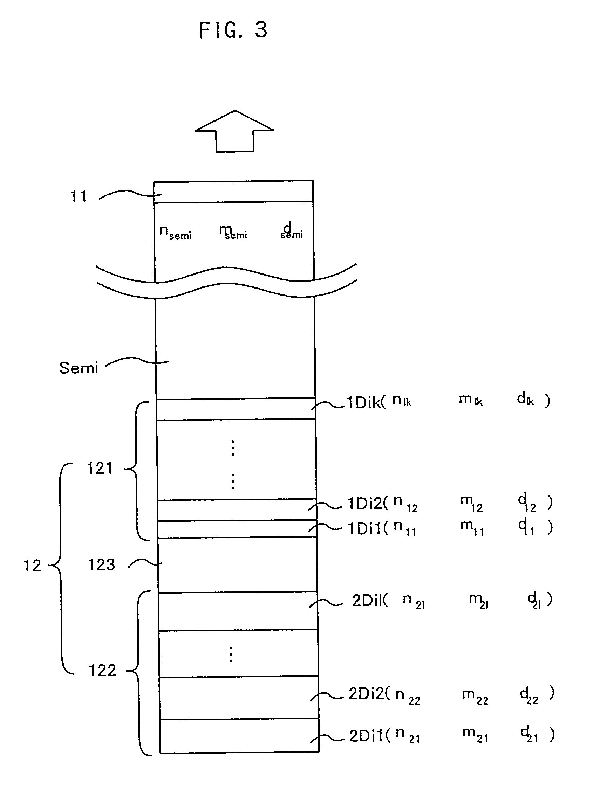

A structure of the multi-layered film (reflective film) of the backside facet in the two-wavelength semiconductor laser device is in common for the two semiconductor laser elements and, as shown in Fig. 3, constituted of, for instance, three regions. That is, the multi-layered film 12 includes a first reflective region 121 that is constituted of dielectric films 1Di1, ... 1Dik deposited in k layers on a side that is in contact with a semiconductor Semi that is a semiconductor laser body; and a second reflective region 122 that is constituted of dielectric films 2Di1, ... 2Di1 deposited in 1 layers that are more separated from the semiconductor Semi than the first reflective region.

Each of the dielectric films 1Di1, ... 1Dik of the first reflective region 121 has a predetermined optical thickness (refractive index × film thickness) to the first wavelength λ₁, and the predetermined optical thicknesses are each set at (2p + 1)/4 × λ₁ (wherein p = 0, 1, 2, ...). Each of the dielectric films 2Dil, ... 2Dil of the second reflective region 122 has a predetermined optical thickness to the second wavelength λ₂, and the predetermined optical thicknesses are each set at (2q + 1) / 4 × λ₂ (wherein q = 0, 1, 2, ...). In order to obtain refractive index steps, each of the dielectric films is set differently in the refractive index from adjacently ones. Therefore, the respective film thicknesses become different from one another.

In the above structure, the phases of lights reflected by the first reflective region 121 and the second reflective region 122 are not always coincident with each other. Accordingly, the multi-layered film 12 may further contain a phase adjustment region 123 between the reflective regions 121 and 122. Since light radiated from the semiconductor has two wavelengths λ₁, λ₂, within a range that makes the respective phase differences of both wavelengths smaller, an optical thickness of the phase adjustment region 123 is determined. The phase adjustment region 123 is made of a single layer dielectric film that is either higher or lower in the refractive index than both dielectric films in the first and second reflective regions 121, 122 that come into contact therewith.

Another method of determining the optical thickness of the multi-layered film 12 is carried out as follows. That is, in a system where the first reflective region is present on the semiconductor and there exists infinite phase adjustment region thereon, the first reflective region is constituted of a multi-layered film the reflectance of which, seen from the semiconductor, becomes substantially the same as the first predetermined reflectance R₁ to the first wavelength λ₁.

The second reflective region is constituted of such a multi-layered film, in a system where the second reflective region is present on the phase adjustment region, the reflectance of which, seen from the phase adjustment region, becomes substantially the same as the second predetermined reflectance R₂ to the second wavelength λ₂.

As to the optical thickness of the phase adjustment region, the film thickness d₃ and the refractive index n₃ defining the optical thickness are determined such that the reflectance of a reflective film as a whole becomes the first predetermined reflectance R₁ to the first wavelength λ₁ and the second predetermined reflectance R₂ to the second wavelength λ₂.

### <Example of determination of multi-layered film>

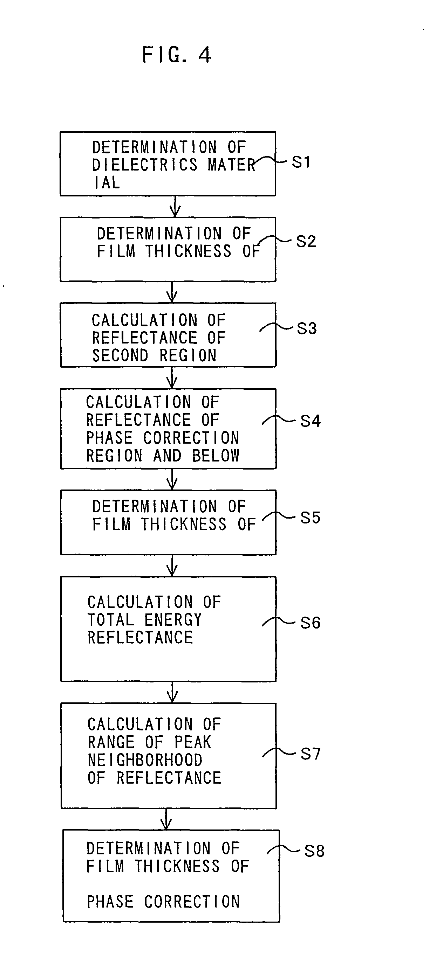

The method of determining a multi-layered film according to the invention will be explained based on a flowchart shown in Fig. 4.

As a first step (S1), in order that for all of the first and second reflective regions as well as the phase adjustment region, a high refractive index material and a low refractive index material are alternately disposed, dielectrics materials of the respective layers are determined. In k layers of dielectrics in the first reflective region, their refractive indices are denoted as n₁₁, n₁₂, ... n₁ₖ to the first wavelength and m₁₁, m₁₂, ... m₁ₖ to the second wavelength, and their thicknesses are in terms of d₁₁, d₁₂, ... d₁ₖ . In 1 layers of dielectrics in the second reflective region, their refractive indices are denoted as n₂₁, n₂₂, ... n₂₁ to the first wavelength and m₂₁, m₂₂, ... m₂₁ to the second wavelength, and their thicknesses are in terms of d₂₁, d₂₂, ... d₂₁ · In the phase adjustment region, its refractive index is denoted as n₃ to the first wavelength and m₃ to the second wavelength, and its thickness is in terms of d₃.

In the next place, as a second step (S2), film thicknesses d₂₁, d₂₂, ... d₂₁ of the respective layers in the second reflective region 122 are determined so that the optical thicknesses become (2p + 1) /4 × λ₂ (wherein p = 0, 1, 2, ...) to the second wavelength λ₂.

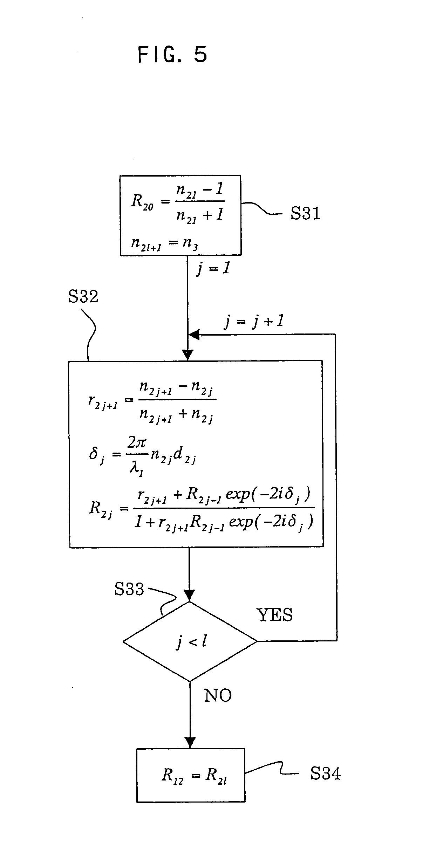

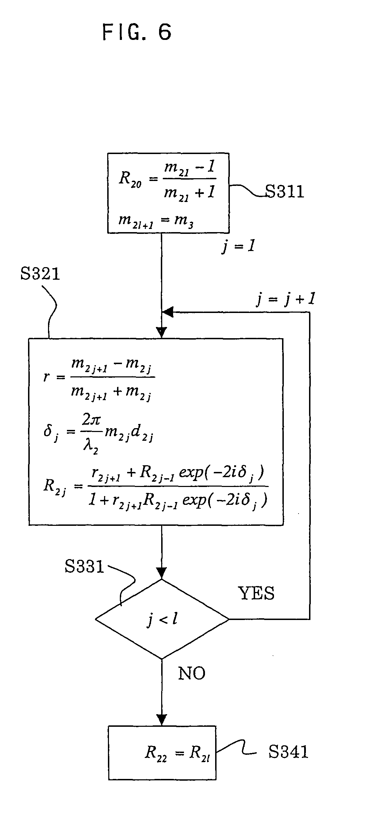

Next, as a third step (S3), the reflectances R₁₂, R₂₂ of the second reflective region to the first and second wavelengths λ₁, λ₂ seen from the single layer phase adjustment region (refractive indices to the first and second wavelengths: n3 and m3) are calculated, respectively. In the third step, as shown in Fig. 5, the refractive index n₃ of the phase adjustment region to the first wavelength and the reflectance of an initial layer are initially set (S31), then the amplitude reflectance R₂ⱼ is repeatedly calculated based on the reflectance r_{2j + 1} and the phase retardation δⱼ of the respective layers up to the predetermined 1 layer (S32). On reaching the 1 layer (S33), the reflectance R₁₂ of the second reflective region to the first wavelength can be obtained (S34) . Further, similarly, as shown in Fig. 6, the refractive index m₃ of the phase adjustment region to the second wavelength and the reflectance of an initial layer are initially set (S311), then the amplitude reflectance R₂ⱼ is repeatedly calculated based on the reflectance r₂ⱼ₊₁ and the phase retardation δⱼ of the respective layers up to the predetermined 1 layer (S321). On reaching the 1 layer (S331), the reflectance R₂₂ of the second reflective region to the second wavelength can be obtained (S341).

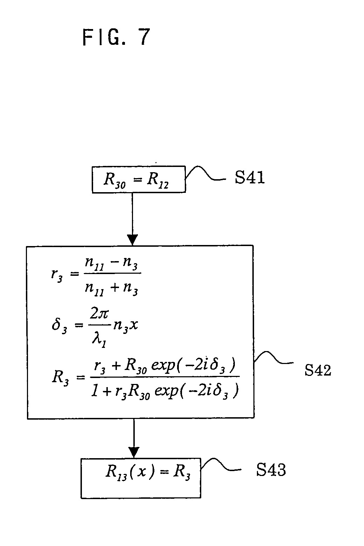

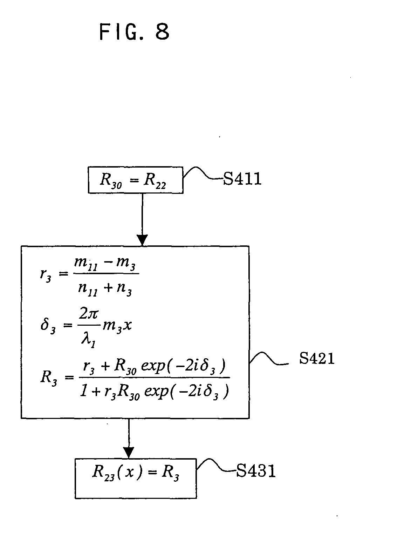

Subsequently, as a fourth step (S4) shown in Fig. 4, with the film thickness of the single layer phase adjustment region as variable x, the reflectances R₁₃ (x), R₂₃ (x) to the first and second wavelengths λ₁, λ₂ of the phase adjustment region and the second reflective region seen from the first contact region in the first reflective region with the phase adjustment region (refractive indices to the first and second wavelengths: n₁₁ and m₁₁) are calculated by use of the reflectances R₁₂, R₂₂. In the fourth step, as shown in Fig. 7, the reflectance R₁₂ is set as an initial value (S41), then the amplitude reflectance R₃ is calculated based on the single layer reflectance r₃ and the phase retardation δ₃ (S42), and thereby a result to the first wavelength, R₃ = R₁₃ (x), can be obtained (S43) . Furthermore, similarly to the above, as shown in Fig. 8, the reflectance R₂₂ is set as an initial value (S411), then the amplitude reflectance R₃ is calculated based on the single layer reflectance r₃ and the phase retardation δ₃ (S421), and thereby a result to the second wavelength, R₃ = R₂₃ (x), can be obtained (S431).

In the next place, as a fifth step (S5) shown in Fig. 4, the film thicknesses d₁₁, d₁₂, ... d₁ₖ of the respective layers in the first reflective region 121 are determined so that the optical thickness becomes (2q + 1) /4 × λ1 (wherein, q = 0, 1, 2, ...) to the first wavelength λ₁ (S5).

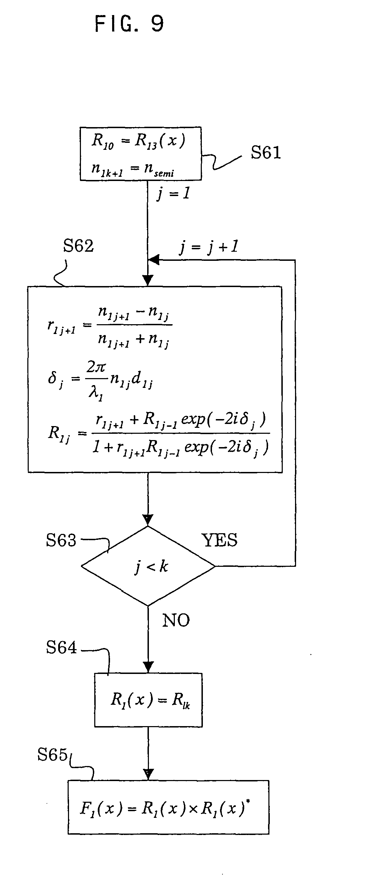

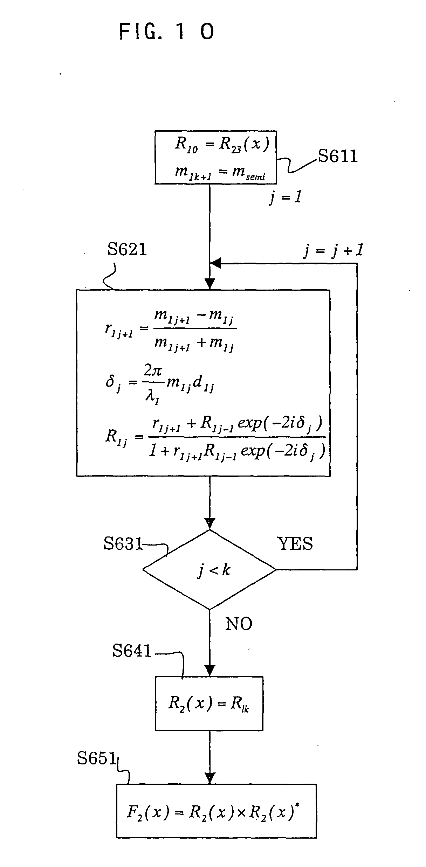

Subsequently, as a sixth step (S6), the reflectances R₁ (x), R₂ (x) of the multi-layered film as a whole for each wavelength seen from the semiconductor to the first and second wavelengths λ₁, λ₂, (reflectances to the first and second wavelengths: nₛₑₘ₁ and mₛₑₘ₁) respectively, are calculated with the obtained reflectances R₁₃ (x), R₂₃ (x), and thereby the energy reflectances F₁ (x) = R₁ (x) × R₁ (x) *, F₂ (x) R₂ (x) × R₂ (x) * are obtained. Here, the R₁ (x) * and R₂ (x) * denote complex conjugate values of the R₁ (x), R₂ (x), respectively. In the sixth step, as shown in Fig. 9, to the first wavelength, the reflectance nₛₑₘ₁ of the semiconductor to the first wavelength and the obtained reflectance R₁₃ (x) are set as initial values (S61), then the amplitude reflectance R₁ⱼ is repeatedly calculated based on the reflectance r_{1j + 1} and the phase retardation δⱼ of the respective layers up to the predetermined k layer (S62). Upon reaching the k layer (S63), the reflectance R₁ (x) of the whole multi-layered film to the first wavelength is obtained (S64). Subsequently, the energy reflectance F₁ (x) = R₁ (x) × R₁ (x) * to the first wavelength is calculated (S65). Furthermore, similarly to the above, as shown in Fig. 10, to the second wavelength, the reflectance mₛₑₘᵢ of the semiconductor to the second wavelength and the obtained reflectance R₂₃ (x) are set as initial values (S611), then the amplitude reflectance R₁ⱼ is repeatedly calculated based on the reflectance r₁ⱼ₊₁ and the phase retardation δⱼ of the respective layers up to the predetermined k layer (S621). Upon reaching the k layer (S631), the reflectance R₂ (x) of the whole multi-layered film to the second wavelength is obtained (S641). Subsequently, the energy reflectance F₂(x) = R₂(x) × R₂ (x) * to the second wavelength is calculated (S651).

In the next place, as a seventh step (S7) shown in Fig. 4, since the reflectance of the multi-layered film as a whole to each of the first and second wavelengths λ₁, λ₂ varies according to the film thickness x of the single layer phase adjustment region, a range of the film thickness x of the phase adjustment region where high reflectance can be obtained to each of the wavelengths is calculated. That is, with x that satisfies F₁' (x) = 0 and F₁' ' (x) < 0 as d₁ₚ, a range of x, d₁ₘᵢₙ ≤ x ≤ d₁ₘₐₓ, that satisfies F₁ (x) ≥ F₁(d₁ₚ) × a, is obtained. Furthermore, with x that satisfies F₂' (x) = 0 and F₂" (x) < 0 as d₂ₚ, a range of x, d₂ₘᵢₙ ≤ x ≤ d₂ₘₐₓ, that satisfies F₂ (x) ≥ F₂(d₂ₚ) × a is obtained (S7). Here, a can be set at, for instance, 0.95.

Subsequently, as an eighth step (S8) shown in Fig. 4, the film thickness of the phase adjustment layer is determined in the range that satisfies d₁ₘᵢₙ ≤ x ≤ d₁ₘₐₓ and d₂ₘᵢₙ ≤ x ≤ d₂ₘₐₓ.

According to the present invention, even when two or more wavelengths are relatively largely different from each other, a multi-layered film structure that can be high in the reflectance to a plurality of wavelengths can be attained.

### <Embodiments>

With the first and second wavelengths λ₁ and λ₂ set at 405 nm and 650 nm respectively, a two-wavelength semiconductor laser device is designed and manufactured.

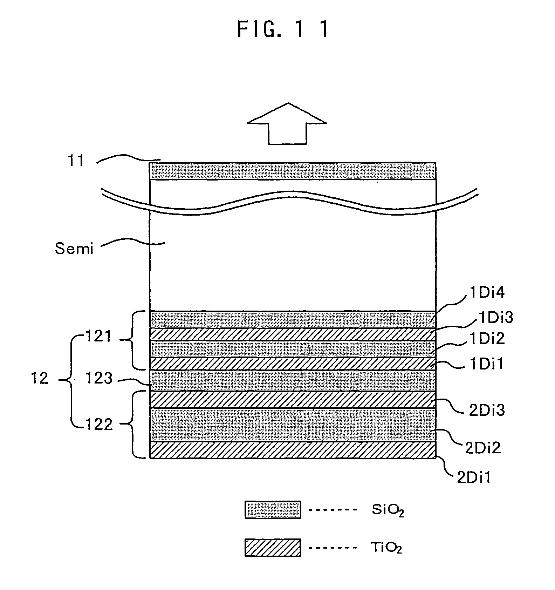

In Fig. 11, a configuration example (I) of a multi-layered film of a two-wavelength semiconductor laser device according to an embodiment is shown. A first reflective region 121 in contact with a semiconductor Semi has a structure of four layers and is made of dielectric films 1Di1, ... 1Di4. A second reflective region 122 deposited more separated from the semiconductor Semi than the first reflective region is made of three layers of dielectric films 2Di1, ... 2Di3. A phase adjustment region 123 between the both reflective regions is a single layer.

The first reflective region 121 that is in contact with the semiconductor is designed so as to be high in the reflectance to the wavelength 405 nm. Specifically, a dielectrics that is low in the refractive index to the wavelength 405 nm and a dielectrics that is high in the refractive index thereto are alternately deposited with film thicknesses such that the respective optical thicknesses (refractive index × film thickness) become (2p + 1) /4 × 405 nm (wherein, p = 0, 1, 2, ...). For instance, when SiO₂ and TiO₂, respectively, are used as a low refractive index dielectrics material and a high refractive index material, the refractive indices to wavelength 405 nm, respectively, are 1.47 and 2.98. Accordingly, film thicknesses where the optical thicknesses become 101 nm at p = 0 in the above equation become 69 nm and 34 nm, respectively. Accordingly, as shown in Fig. 11, with these film thicknesses of 69 nm and 34 nm, each of dielectric films of SiO₂ and TiO₂ is alternately deposited as to be 1Di1, ... 1Di4. The second reflective region 122 that is in contact with air is designed so as to be high in the reflectance to the wavelength 650 nm. Specifically, a dielectrics that is low in the refractive index to the wavelength 650 nm and a dielectrics that is high in the refractive index thereto are alternately deposited with film thicknesses such that the respective optical thicknesses (refractive index × film thickness) become (2q + 1)/4 × 650 nm (wherein, q = 0, 1, 2, ...). For instance, when SiO₂ and TiO₂ are used as a low refractive index dielectrics material and a high refractive index material respectively, the refractive indices to the wavelength 650 nm, respectively, are 1.45 and 2.57. Accordingly, film thicknesses where the optical thicknesses become 162 nm at q = 0 in the above equation become 112 nm and 63 nm, respectively. Accordingly, as shown in Fig. 11, with these film thicknesses of 112 nm and 63 nm, each of dielectric films of SiO₂ and TiO₂ is alternately deposited to be 2Di1, ... 2Di3. That is, in the multi-layered structure shown in Fig. 11, the dielectric film of the first reflective region 121 is formed into a multi-layered film made of two pairs of SiO₂ (69 nm) and TiO₂ (34 nm), the second reflective region 122 is formed into a multi-layered film made of TiO₂ (63 nm)/SiO₂ (112 nm)/TiO₂ (63 nm), and a film thickness of the phase adjustment layer 123 that is, for instance, a single layer film of SiO₂ is set at x (nm).

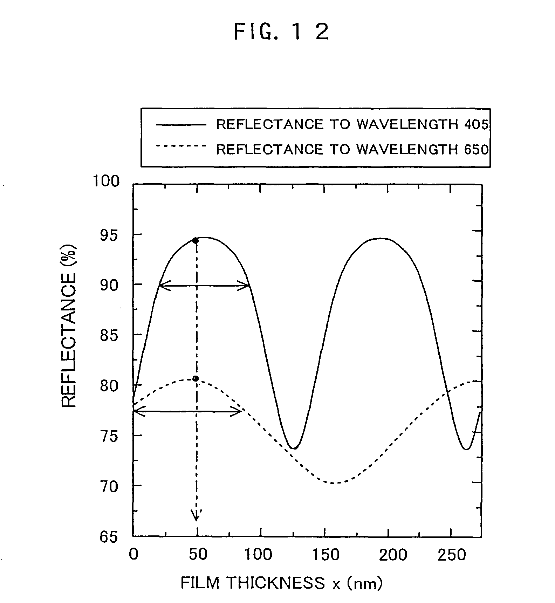

The film thickness x of a single layer of the phase adjustment region 123 that uses SiO₂ as the dielectrics is determined based on the flowchart shown in Fig. 4. In this case, the reflectance of the multi-layered film 12 of the two-wavelength semiconductor laser device exhibits the dependency on the film thickness x of the phase adjustment region. That is, as shown in Fig. 12, since the reflectance periodically varies with the film thickness x of the phase adjustment region 123 for each of oscillation wavelengths, the film thickness x of the phase adjustment region is determined in the vicinity of the peak thereof. For instance, as obvious from Fig. 12, in the film thickness of 50 nm, the reflectance of 94% is obtained to the wavelength 405 nm and that of 80% is obtained to the wavelength of 650 nm. This film thickness is selected for the phase adjustment region. In practice, according to the first and second wavelengths, 405 nm and 650 nm, periods of the reflectance variation are different from each other. Therefore, the film thickness of the phase adjustment region is selected so that the reflectance may be high for both the wavelengths. A range of the film thickness x of the phase adjustment region 123 where, for instance, 95% or more of the peak intensity can be obtained is 17 nm ≤ x ≤ 91 nm for the wavelength of 405 nm and 0 nm ≤ x ≤ 98 nm for the wavelength of 650 nm. Accordingly, the film thickness is selected among these. Thus, as to the film thickness x of the phase adjustment region 123, a range of the film thickness where the predetermined ratio of the peak intensity can be obtained in each of the wavelengths is obtained, and from a region where the film thickness ranges overlap each other, the film thickness x can be selected.

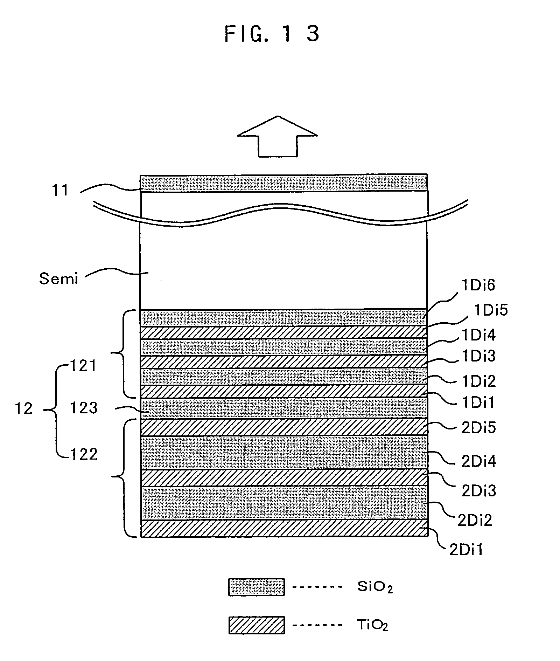

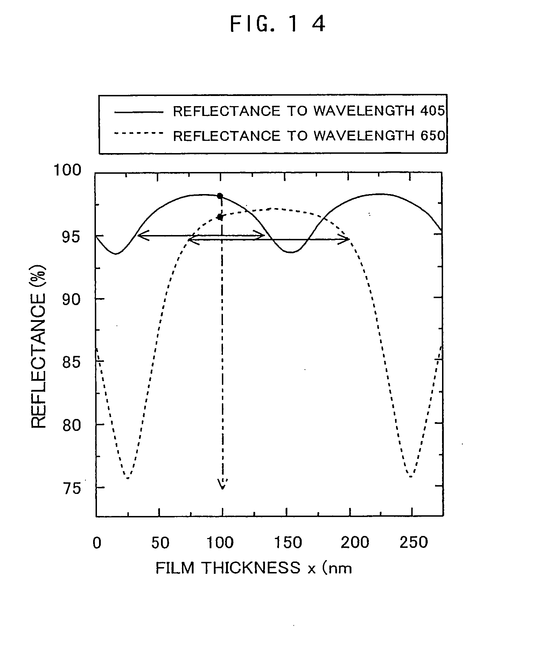

In Fig. 13, a configuration example of a multi-layered film (II) of a two-wavelength semiconductor laser device according to another embodiment is shown. Dielectrics films 1Di1, ... 1Di6 of the first reflective region are formed into a multi-layered film of three pairs of SiO₂ (69 nm) and TiO₂ (34 nm), that is, 6 layers. The dielectric films 2Di1, ... 2Di5 of the second reflective region are formed into a multi-layered film of TiO₂ (63 nm)/SiO₂ (112 nm) /TiO₂ (63 nm)/SiO₂ (112 nm) /TiO₂ (63 nm), that is, 5 layers. And the phase adjustment region is made of a single layer film of SiO₂ having a film thickness x (nm). As shown in Fig. 14, the reflectance of the multi-layered film 12 exhibits the dependency on the film thickness x of the phase adjustment region. Accordingly, a range of the film thickness x where the intensity becomes, for instance, 95% or more of the peak intensity is 25 nm ≤ x ≤ 140 nm for the wavelength of 405 nm and 75 nm ≤ x ≤ 190 nm for the wavelength of 650 nm. Accordingly, the film thickness is selected of the overlap thereof. For instance, at the film thickness of 100 nm, values of the reflectance to wavelengths 405 and 650 nm are 98% and 96%, respectively. Therefore, very high reflectance can be obtained for both wavelengths.

As another embodiment, in a two-wavelength semiconductor laser device according to a configuration example of multi-layered film (III), similarly to the above embodiment, the multi-layered film has a structure that includes a first reflective region in contact with the semiconductor and made of dielectric films of 2.5 pairs of SiO₂ (69 nm)/TiO₂ (34 nm), that is, 5 layers. A second reflective region deposited more separated from the semiconductor than the first reflective region and made of dielectric films of two pairs of SiO₂ (112 nm)/TiO₂ (63 nm), that is, 4 layers. And a phase adjustment region TiO₂ (75 nm) between both reflective regions.

The values of reflectance to the wavelengths 405 nm and 650 nm in the configuration examples (I), (II) and (III) of the above multi-layered films are summarized in Tables 1, 2 and 3.

**Table 1**

| Configuration example I | | | | Light reflectance at 405 nm | Light reflectance at 650 nm |
|---|---|---|---|---|---|
| | Dielectrics | Film thickness (nm) | Repetition number of layers | 94% | 80% |
| First reflective region | SiO₂ | 69 | 2 pairs | | |
| | TiO₂ | 34 | | | |
| Phase adjustment region | SiO₂ | 50 | | | |
| Second reflective region | TiO₂ | 63 | 1.5 pairs | | |
| | SiO₂ | 112 | | | |

**Table 2**

| Configuration example II | | | | Light reflectance at 405 nm | Light reflectance at 650 nm |
|---|---|---|---|---|---|
| | Dielectrics | Film thickness (nm) | Repetition number of layers | 98% | 96% |
| First reflective region | SiO₂ | 69 | 3 pairs | | |
| | TiO₂ | 34 | | | |
| Phase adjustment region | SiO₂ | 100 | | | |
| Second reflective region | TiO₂ | 63 | 2.5 pairs | | |
| | SiO₂ | 112 | | | |

**Table 3**

| Configuration example III | | | | Light reflectance at 405 nm | Light reflectance at 650 nm |
|---|---|---|---|---|---|
| | Dielectrics | Film thickness (nm) | Repetition number of layers | 95% | 92% |
| First reflective region | SiO₂ | 69 | 2.5 pairs | | |
| | TiO₂ | 34 | | | |
| Phase adjustment region | TiO₂ | 75 | | | |
| Second reflective region | SiO₂ | 112 | 2 pairs | | |
| | TiO₂ | 63 | | | |

In the above embodiments, cases where SiO₂ and TiO₂ are used as the materials of the multi-layered films are explained. However, materials such as Al₂O₃, ZrO₂ , Si₃N₄, Ta₂O₅ and so on may be used in appropriate combinations.

A reflective region of a quarter-wave film to a short wavelength and a reflective region of a quarter-wave film to a long wavelength may be deposited in either order. However, in the first reflective region, when the low reflectance is set to the second wavelength (wavelength 650 nm in the above embodiment), over a wide range of the film thickness x of the phase adjustment region, the reflectance of the multi-layered film 12 to the second wavelength can be made higher. The dielectrics multi-layered film is easy in designing the reflectance high to short wavelengths with low to long wavelengths. Accordingly, as to the order of deposition of the first reflective region and the second reflective region, it is preferable to form a quarter-wave film to the short wavelength in the first reflective region and a quarter-wave film to the long wavelength in the second reflective region. A case where as to an order of deposition of the first reflective region and the second reflective region, a quarter-wave film to the short wavelength is formed in the first reflective region and a quarter-wave film to the long wavelength is formed in the second reflective region was explained. In another embodiment, even if the second wavelength is reflected by the first reflective region, as far as the phase difference of reflected light from the first reflective region and reflected light from the second reflective region can be sufficiently adjusted in the phase adjustment region, high reflectance can be obtained even to the second wavelength. Accordingly, the reflective region of a quarter-wave film to a short wavelength and the reflective region of a quarter-wave film to a long wavelength may be deposited in whatever order.

Furthermore, in the above embodiments, the phase adjustment region is disposed between the first reflective region and the second reflective region. However, depending on the number of layers in the first and second reflective regions, in some cases, when the film thickness of the phase adjustment region is zero, the phase difference of both wavelengths becomes smaller. In this case, the multi-layered film is formed with the first and second reflective regions in direct contact.

Still furthermore, the two-wavelength semiconductor laser device has been explained above, however, the present invention can be applied also to multi-wavelength semiconductor laser devices having three or more semiconductor laser elements.

According to a multi-wavelength laser of the invention, multi-layered films at facets of a resonator may be obtained with high reflectance to all of a plurality of wavelengths. Therefore, the characteristics of all laser elements can be improved. Furthermore, since the film formation can be collectively performed to all of the laser elements, the productivity can be also improved.

Furthermore, even in the case where a distance between light emitting spots is so small (for instance 50 µm or less) that a conventional method in which films of different structures are separately formed by use of masks can be hardly applied, according to the invention, a multi-layered film that has high reflectance to both wavelengths can be easily manufactured. Still furthermore, even in the case where difference of two wavelength ranges is so large (for instance, 405 nm band and 650 nm band) that a conventional method in which a film is designed so as to adapt to an average wavelength of two wavelengths can be applied with difficulty, the multi-layered film according to the invention can obtain sufficient characteristics.

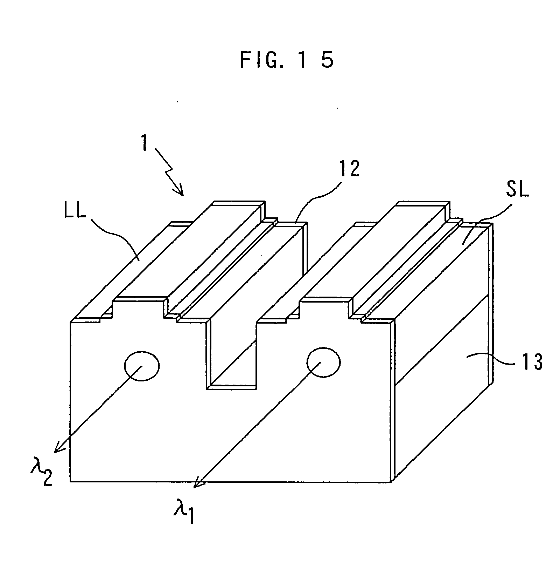

The two-wavelength semiconductor laser device shown in Fig. 1 is manufactured by bonding two semiconductor laser elements formed on separate substrates. However, in another embodiment, as shown in Fig. 15, the two-wavelength semiconductor laser device may have a monolithic structure in which two ridge type semiconductor laser elements that oscillate at wavelengths λ₁ and λ₂, which are different from each other such as 650 nm and 780 nm, are formed on the same substrate with an isolation groove intervened therebetween. As materials that constitute each of active layers of a plurality of semiconductor laser elements, other than GaN and AlGaInP, any material that can be used in the relevant field, such as AlGaAs materials, InGaAsP materials, PbSnTe materials, can be used. By appropriately adjusting compositional ratios of these materials, semiconductor laser elements having an active layer, a cladding layer and so on that have desired characteristics can be obtained. Furthermore, an active layer of a semiconductor laser diode may have, other than a multiple quantum well structure, a structure such as a single quantum well structure, a bulk active layer structure and so on.

## Claims

1. A multi-wavelength semiconductor laser device comprising:
a plurality of semiconductor laser elements that oscillate at wavelengths that are different from each other,
wherein the plurality of semiconductor laser elements have a reflective film that is deposited on at least one of a front facet and a backside facet thereof and has a multilayer structure common to the semiconductor laser elements,
wherein the reflective film includes first and second reflective regions disposed in a film thickness direction thereof, the first reflective region having a first predetermined reflectance to a first wavelength oscillated at a first semiconductor laser element of the semiconductor laser elements; and the second reflective region having a second predetermined reflectance to a second wavelength that is oscillated at a second semiconductor laser element other than the first semiconductor laser element and different from the first wavelength.

2. The multi-wavelength semiconductor laser device as set forth in claim 1, wherein each of the first and second reflective regions includes a plurality of dielectric films layered one another and having refractive indexes respectively wherein the refractive indexes of the dielectric films adjacently deposited are different from each other.

3. The multi-wavelength semiconductor laser device as set forth in claim 2, wherein each of the plurality of dielectric films of the first reflective region has an optical thickness n₁ × d₁ expressed by n₁ × d₁ = (2p + 1 )/4 × λ₁ (wherein, λ₁ denotes a first wavelength; n₁ denotes a refractive index to the first wavelength; d₁ denotes a film thickness; and p denotes 0, 1, 2, ...); and each of the plurality of dielectric films of the second reflective region has an optical thickness n₂ × d₂ expressed by n₂ × d₂ = (2q + 1)/4 × λ₂ (wherein, λ₂ denotes a second wavelength; n₂ denotes a refractive index to the second wavelength; d₂ denotes a film thickness; and q denotes 0, 1, 2, ...).

4. The multi-wavelength semiconductor laser device as set forth in any one of claims 1-3, wherein the reflective film has a phase adjustment region that is disposed between the first and second reflective regions to adjust a phase difference of light transmitting therethrough.

5. The multi-wavelength semiconductor laser device as set forth in claim 4, wherein the phase adjustment region is made of a single layer dielectric film having an optical thickness defined by a film thickness and a refractive index which are determined such that the reflectance of the reflective film as a whole becomes a first predetermined reflectance to the first wavelength and a second predetermined reflectance to the second wavelength.

6. The multi-wavelength semiconductor laser device as set forth in claim 4 or 5, wherein the phase adjustment region is made of a single layer dielectric film that has a refractive index different from that of adjacent one of the first and second reflective regions.

7. The multi-wavelength semiconductor laser device as set forth in any one of claims 4-6, wherein the phase adjustment region is made of a single layer dielectric film that has a film thickness different from that of adjacent one of the first and second reflective regions.

8. The multi-wavelength semiconductor laser device as set forth in any one of claims 4-7, wherein the phase adjustment region is made of a single layer dielectric film that has an optical thickness different from those of the respective dielectric films of the first and second reflective regions.

9. The multi-wavelength semiconductor laser device as set forth in any one of claims 1-8, wherein the reflective film is deposited on the backside facet and set higher in the reflectance at the backside facet than the reflectance at the facet.

10. The multi-wavelength semiconductor laser device as set forth in claim 1, wherein the multi-wavelength semiconductor laser device is made only of the first semiconductor laser element and the second semiconductor laser element, the respective ones being a 405 nm band semiconductor laser element and a 650 nm band semiconductor laser element.

11. A method of manufacturing a multi-wavelength semiconductor laser device that includes a plurality of semiconductor laser elements each of which oscillates at a wavelength different from each other, comprising the steps of:
forming a laser bar for a plurality of semiconductor laser elements that oscillate at different wavelengths;
forming, over all facets of the laser bar corresponding to the plurality of semiconductor laser elements, a first reflective region that includes a plurality of dielectric films each of which is different in the refractive index from adjacently deposited ones and has a first predetermined reflectance to a first wavelength; and
forming, on the first reflective region, a second reflective region that includes a plurality of dielectric films each of which is different in the refractive index from adjacently deposited ones and has a second predetermined reflectance to a second wavelength that is oscillated by a second semiconductor laser element other than the first semiconductor laser element and different from the first wavelength.

12. A method of manufacturing a multi-wavelength semiconductor laser device as set forth in claim 11, further comprising a step of forming a phase adjustment region that is disposed between the first and second reflective regions and adjusts phase difference of transmitting light.

13. The method of manufacturing a multi-wavelength semiconductor laser device as set forth in claim 12, wherein each of the plurality of dielectric films of the first reflective region has an optical thickness n₁ × d₁ expressed by n₁ × d₁ = (2p + 1)/4 × λ₁ (wherein, λ₁ denotes a first wavelength; n₁ denotes a refractive index to the first wavelength; d₁ denotes a film thickness; and p denotes 0, 1, 2, ...); and each of the plurality of dielectric films of the second reflective region has an optical thickness n₂ × d₂ expressed by n₂ × d₂ = (2q + 1)/4 × λ₂ (wherein, λ₂ denotes a second wavelength; n₂ denotes a refractive index to the second wavelength; d₂ denotes a film thickness; and q denotes 0, 1, 2, ...).

14. The method of manufacturing a multi-wavelength semiconductor laser device as set forth in claim 12, wherein the phase adjustment region is made of a single layer dielectric film having an optical thickness defined by a film thickness and a refractive index which are determined such that the reflectance of the reflective film as a whole becomes a first predetermined reflectance to the first wavelength and a second predetermined reflectance to the second wavelength.

15. The method of manufacturing a multi-wavelength semiconductor laser device as set forth in claim 12, wherein the phase adjustment region is made of a single layer dielectric film that has a refractive index different from that of adjacent one of the first and second reflective regions.

16. The method of manufacturing a multi-wavelength semiconductor laser device as set forth in claim 12, wherein the phase adjustment region is made of a single layer dielectric film that has a film thickness different from that of adjacent one of the first and second reflective regions.

17. The method of manufacturing a multi-wavelength semiconductor laser device as set forth in claim 12, wherein the phase adjustment region is made of a single layer dielectric film that has an optical thickness different from those of the respective dielectric films of the first and second reflective regions.

18. The method of manufacturing a multi-wavelength semiconductor laser device as set forth in claim 11, wherein the reflective film is deposited on the backside facet and set higher in the reflectance at the backside facet than the reflectance at the front facet.

19. The method of manufacturing a multi-wavelength semiconductor laser device as set forth in claim 11, wherein the multi-wavelength semiconductor laser device is made only of the first semiconductor laser element and the second semiconductor laser element, the respective ones being a 405 nm band semiconductor laser element and a 650 nm band semiconductor laser element.
